# EUROPEAN PATENT SPECIFICATION

(11) **EP 1 121 704 B1**
(45) Date of publication and mention of the grant of the patent: **21.06.2006**
(21) Application number: 99969178.5
(22) Date of filing: 13.09.1999
(51) Int. Cl.: H01J 37/09, H01J 29/84, H01J 3/40

(54) **ELECTRON BEAM APERTURE ELEMENT WITH BEAM SHIELDING**
APERTURBLENDE MIT STRAHLABSCHIRMUNG FÜR ELEKTRONENSTRAHL
ELEMENT D'OUVERTURE POUR FAISCEAU D'ELECTRONS AVEC BLINDAGE DE FAISCEAU

(30) Priority: 16.09.1998 GB 9820205
(43) Date of publication of application: 08.08.2001
(73) Proprietor: Leica Microsystems Lithography Ltd., Cambridge CB1 3QH (GB)
(72) Inventor: ZHANG, Tao, Cambridge CB1 4YU (GB)
(74) Representative: Wise, Stephen James
(86) International application number: PCT/EP1999/006770
(87) International publication number: WO 2000/016370

(56) References cited:
- EP-A- 0 197 579
- EP-A- 0 308 560
- US-A- 4 651 003
- US-A- 5 493 116
- PATENT ABSTRACTS OF JAPAN vol. 005, no. 070 (E-056), 12 May 1981 (1981-05-12) & JP 56 019856 A (HITACHI LTD;OTHERS: 01), 24 February 1981 (1981-02-24)
- PATENT ABSTRACTS OF JAPAN vol. 009, no. 065 (E-304), 26 March 1985 (1985-03-26) & JP 59 203353 A (SONY KK), 17 November 1984 (1984-11-17)

## Description

The present invention relates to an electron beam aperture element and to an electron beam column with at least one such element.

Aperture elements are used in electron beam columns to influence beam shape or travel downstream of an electron gun and before electron emission from the column. Such an element typically consists of a member with a passage for part or all of the beam and a blocking surface adjoining an entry opening of the passage. The blocking surface usually lies at least partly in a plane perpendicular to the axis of the passage. When the element is to serve for beam shaping, such as in association with a focussing lens, the passage is calibrated at least at its entry opening and limits the beam to a desired diameter. The blocking surface extends around the entry opening and blocks onward travel of any beam electrons outside that diameter. When the element serves to control travel of the entire beam, such as in a blanking unit operable to provide transient cut-off of the beam, the beam as a whole is deflected away from the entry opening so that all beam electrons impinge on the blocking surface. The deflection is generally always to the same side of the entry opening, but for ease of construction and assembly the blocking surface completely surrounds the entry opening.

A particular problem with an aperture element used for such purposes is the deleterious effect on beam shape and/or orientation resulting from electron departure from the blocking surface. The departing electrons consist of backscattered electrons and secondary electrons, which are impelled back along the column in all directions and give rise to charge locations wherever they impinge in significant concentrations upstream of the element. If a charge location is eccentric with respect to the column axis, as is usually the case and invariably so when the electrons are issued from a blanking unit, the influence of the charge can cause distortion of the beam or deviation from strict coaxiality with the column axis. This then requires corrective measures to restore beam alignment, failing which position errors can arise in the part of the beam emitted from the column. Any such errors are of critical significance in, for example, an electron beam lithography machine in which the beam generates a writing spot to be positioned with a tolerance of a few nanometres on an electron-sensitive substrate surface.

It is therefore the object of the invention to mitigate the effects of electrons scattered from an electron beam aperture element, in particular so as to prevent generation of undesired charge zones liable to act on the beam before entry into the element. Other objects and advantages of the invention will be apparent from the following description.

According to one aspect of the present invention there is provided an electron beam aperture element comprising a beam travel control member provided with a passage opening for travel therethrough of at least part of an electron beam and with a blocking surface for blocking travel of part or all of the beam through the passage opening, characterised in that the aperture element further comprises a trap chamber which serves to trap scattered electrons resulting from blocking or partial blocking of the beam and which has an entrance for the beam at such a spacing from the passage opening that the majority of scattered electrons within the chamber is dispersed therein before reaching the entrance, and a shielding member which is disposed in the chamber to extend between the chamber entrance and the passage opening over at least the major part of said spacing and which has a smaller surface area than the wall of the chamber so as to be liable to be charged by the electrons to a lower potential than the wall thereby to electrically shield the beam relative to the wall.

In the case of such an aperture element, the backscattered and secondary electrons produced as a result of partial or complete blocking of the electron beam are dispersed in a trap chamber of such size that only a small proportion of the electrons reaches the chamber entrance, even though the entrance has to be of sufficient width to accommodate a beam diameter larger than the passage opening diameter in the case of a spray aperture element for beam shaping or to accommodate beam deflection in the case of a blanking aperture element for beam blocking. The backscattered electrons derived from incidence of the beam on the blocking surface in the shaping or blocking process have an angular distribution within the chamber in the form of a diffusion spray or cloud which is shaped in dependence on the cosine of the angle between the blocking surface and beam axis and on the constituent material of that surface, in practice generally a circular pattern with a variable degree of flattening and variable direction of the major axis. The spacing of the chamber entrance from the passage opening is selected so that the electron dispersion in the cloud attains its maximum ahead of the chamber entrance. The dispersed electrons, however, impinge on the wall of the trap chamber and this can create locally charged areas where contaminations, such as dust particles or oil smears, are present. Charging can also occur if, in the case of use of the aperture element in the vacuum environment of an electron beam column, the vacuum is insufficient to counteract high-level surface bombardment by electrons. The shielding member, which can have a very much smaller surface area than the chamber wall, is consequently less susceptible to localised charging and thus lies at a lower potential than the wall so as to be able to protect the beam, during its normal travel through the control member passage opening, from deflection or distortion by charge locations within the chamber. The trap chamber shape thus confines most of the scattered electrons and the shielding member prevents beam alignment or shape problems from arising within the chamber itself.

The shielding member preferably comprises an apertured wall member, such as a grid or grill, bounding a through passage. The wall member is, for preference, substantially cylindrical and the shielding member preferably extends over substantially all of the spacing between the chamber entrance and the passage opening of the control member. Construction of the shielding member from, in effect, a cylindrical grid or grill results in minimal surface area for picking up contaminations chargeable by scattered electrons.

The trap chamber is preferably bounded by a substantially cylindrical inner wall surface of a hollow body and by an inwardly directed face of a closure plate closing the cavity of the body at an end thereof, the closure plate having a central passage opening providing the chamber entrance. The machining of such a hollow body is uncomplicated and the closure plate can be fitted so as to not only close the body cavity, but also to mount or contribute to the mounting of the shielding member. The plate itself can be provided with at least one further passage opening disposed outwardly of the central passage opening and serving for vacuum equalisation between the interior and the exterior of the aperture element when installed in an electron beam column. In order to minimise or avoid escape of scattered electrons through the or each vacuum equalisation passage opening, that passage opening or those passage openings can be aligned with a radial face of an outwardly directed step formed in the inner wall surface of the hollow body and adjacent to the closure plate.

The control member is preferably mounted in the hollow body in the region of an end of the body cavity opposite the closure plate. The blocking surface can be substantially planar, in which case the control member can be formed by a plate with an aperture providing the passage, or can be substantially frusto-conical. In the latter case, the cone angle of the blocking surface can be such as to cause the mean trajectories of electrons departing from the blocked or partially blocked beam to extend at an oblique angle towards the substantially cylindrical inner wall surface of the hollow body, as a result of which the diffusion cloud of scattered electrons is directed entirely or almost entirely away from the chamber entrance. This arrangement provides particularly effective confinement of the scattered electrons to the trap chamber.

According to a further aspect of the invention there is provided an electron beam column comprising a casing, beam generating means arranged in the casing and operable to generate an electron beam, and at least one aperture element, preferably arranged to function as a spray aperture or a blanking aperture, according to the first-mentioned aspect of the invention, the aperture element being arranged in the casing to be in the path of the beam.

An electron beam aperture element with a trap chamber for scattered electrons is disclosed in JP-A-56/019856.

Embodiments of the invention will now be more particularly described with reference to the accompanying drawings, in which:
Fig. 1 is a sectional view of a first aperture element embodying the invention; and
Fig. 2 is a sectional view of a second aperture element embodying the invention.

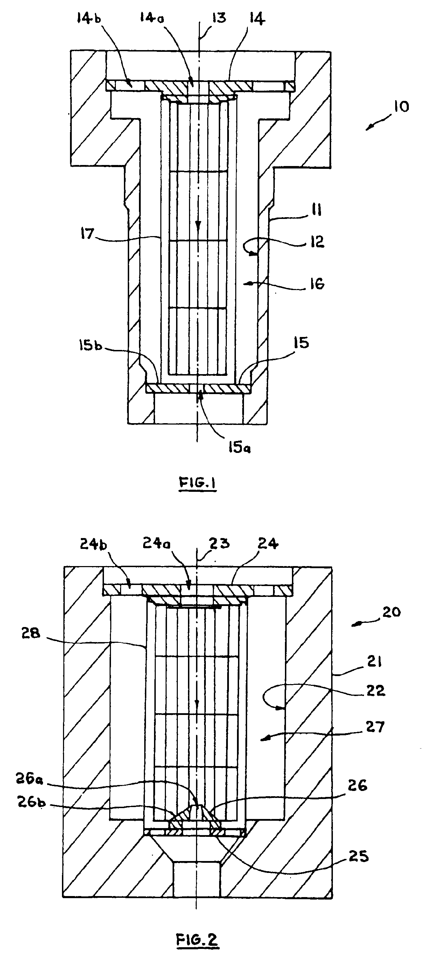

Referring now to the drawings, there is shown an aperture element 10 (Fig. 1) or 20 (Fig. 2) intended to be mounted in the electron beam column of, for example, an electron beam lithography machine and to function as a spray aperture for shaping or a blanking aperture for blocking a high-energy electron beam generated in the column. In the installed position of the aperture and inactive state of the column, the element lies at ground potential.

The aperture element 10 shown in Fig. 1 comprises a hollow body 11 with a cylindrical inner wall surface 12 symmetrical about an axis 13 and bounding the body cavity, which is open at both ends. The inner wall surface 12 has an outwardly directed step towards the upper end of the body, adjoined by a further, smaller outward step providing a seat for a closure plate 14. The plate 14 is fixed in position and closes the body cavity in the region of its upper end.

The inner wall surface 12 additionally has two successive inwardly directed steps towards the lower end of the body 11, the lower one of which steps provides a seat for a beam travel control member in the form of a plate 15 serving to control electron beam travel. The plate 15 is also fixed in position and closes the body cavity in the region of its lower end.

The closure plate 14 is provided with a central passage opening 14a concentric with the axis 13 and a plurality of outlying passage openings 14b aligned with the radial face of the first-mentioned outwardly directed step. The plate 15 is provided with a central passage opening 15a similarly concentric with the axis, but smaller in diameter than the passage opening 14a. The passage opening 15a, which is optionally of calibrated diameter, allows travel through the aperture element along the axis 13 and in the direction of the arrowhead of the electron beam, which, upstream of the plate 15, may have a diameter larger than that of the passage opening and consequently can be shaped by the plate 15 to have the same diameter as the passage opening. The upstream face of the plate constitutes a planar blocking surface 15b serving to block travel of the beam electrons in the part of the beam diameter exceeding the passage opening diameter or to block travel of all of the beam electrons if the beam is deflected sufficiently far from the axis 13. In its travel to the passage opening 15a in the plate 15 the beam passes through the passage opening 14a in the plate 14, for which purpose the diameter of the passage opening 14a must be large enough to allow the beam to pass along the axis 13 or, if the beam is deflected as in the case of a blanking unit, along an axis angled relative to the axis 13 without incidence of any beam electrons on the plate 14.

The inner wall surface 12 of the body 11 and the inwardly directed face of the closure plate 14 together bound a trap chamber 16 for scattered electrons resulting from the partial or complete blocking of the travel of the beam through the passage opening 15a and the consequent collision of some or all of the beam electrons with the blocking surface 15b. The scattered electrons consist of high-energy backscattered electrons from the beam itself and secondary electrons generated by electron bombardment of surfaces within the trap chamber. The backscattered electrons form, within the trap chamber, a diffusion cloud having a circular shape flattened to a greater or lesser degree depending on, in particular, the angle of incidence of the beam on the blocking surface 15b. The height of the trap chamber, as represented by the spacing of the plates 14 and 15 and in particular of the passage opening 14a in the former from the passage opening 15a in the latter, is selected to be sufficiently large for the electrons in the cloud to have achieved maximum dispersion ahead of the passage opening 14a, which forms the entrance to the chamber for the beam and necessarily also an exit for the scattered electrons. Due to the achieved dispersion, the majority of stray electrons are confined to the trap chamber and do not escape back through the chamber entrance.

Within the chamber itself, any dust particles, smears or other contaminations adhering to the inner wall surface 12 of the body 11 or the inward face of the closure plate provide locations susceptible to charging up to a relatively high potential by impinging electrons. If any such charge locations should form, they can exert a distorting influence on the beam during normal travel of the beam through the passage opening 15a. Even slight deflection of the beam from coaxiality with the axis 13 can lead to relatively significant errors in the beam orientation downstream of the aperture element 10. Errors of this kind are particularly problematic in the case of, for example, a beam used to write patterns on a substrate with a high degree of accuracy as described in the introduction. To protect the beam from such influences, a shielding member 17 in the form of a cylindrical metal wire grill is arranged in the chamber concentrically with the axis 13 to extend between the plates 14 and 15, in particular between the chamber entrance formed by the passage opening 14a in the former and the passage opening 15a in the latter. The shielding member 17 is secured at its top end to the plate 14. Because of its mesh construction, the shielding member 17 has a very small surface area by comparison with that of the wall of the chamber and therefore remains largely free of contaminations able to form charge locations. The shielding member 17 thus retains a lower electric potential by comparison with the chamber wall and electrically screens the beam from the higher potential of the wall.

The environment of the column in which the aperture beam is to be mounted is evacuated when the beam is generated and, since the aperture element 10 usually forms a partition element in the column interior, the passage openings 14b in the closure plate 14 function as vacuum pumping holes to permit equalisation of vacuum between the trap chamber and exterior of the aperture element. The alignment of the passage openings 14b with the step face largely screens these passage openings from scattered electrons in the trap chamber. Similar passage openings (not shown) can be present in the control member plate 15.

The plate 15, or at least its blocking surface 15b, consists of a metallic material, such as an aluminium-based alloy, with a low total electron yield. The yield, which is proportional to the atomic number of the material used, is preferably at most about 20 percent with the expected angle of beam incidence. The hollow body 11, closure plate 14 and shielding member 17 are also made of a low-yield material, preferably the same material as the plate 15. The desired minimisation of secondary electron emission can also be achieved, if appropriate, by coating low-yield material on another material having desired other properties.

The aperture element 20 illustrated in Fig. 2 similarly comprises a hollow body 21 with a cylindrical inner wall surface 22 concentric with an axis 23 and a closure plate 24 which is seated on an outwardly directed step of the inner wall surface to close the upper end of the cavity in the body and which is provided with a central passage opening 23a and vacuum equalisation passage openings 23b, the latter in this case not being screened by a step face. The lower end of the cavity is closed by a beam control member which in this instance consists of a plate 25 provided with vacuum pumping holes and carrying a cone body 28 with a bore forming a calibrated passage opening 26a for the beam. The entry opening of the passage opening 26a is surrounded by a frusto-conical blocking surface 26b which, at the upstream side, includes an angle of at least 135°, preferably about 140°, with the axis 23. A sharp edge results at the entry of the passage opening 26a, optionally enhanced by inward taping of the entry end portion of the bore, to provide a clear division between those electrons admitted to and those excluded from the passage opening 26a.

As in the case of the aperture element 10 of Fig. 1, the inner wall surface 22 of the body 21 and the inwardly directed face of the closure plate 24 bound a trap chamber 27 for scattered electrons resulting from partial or complete blocking of the electron beam. Similarly, a low electric potential shielding member 28 having the same function as the shielding member 17 in Fig. 1 is arranged in the trap chamber 27 to electrically shield the beam from the higher electric potential prevailing at the wall of the trap chamber. In the case of the aperture element 20, the cone angle of the blocking surface 26b is such that backscattered electrons derived from the beam depart from the surface in a spray having a mean trajectory which forms an oblique angle with the surface, whereby the departing electrons are directed generally away from the chamber entrance represented by the passage opening 24a. The subsequent deflection of the electrons and emission of secondary electrons take place within the chamber in such a manner that energy dissipation and absorption by the constituent or coated low-yield material of the chamber wall largely preclude escape of damaging stray electrons from the chamber. The frusto-conical blocking surface 26b is more effective than the planar blocking surface 15b and is preferred in cases where the aperture element size is larger and the cone body 26 can thus be produced without undue attention to surface tolerances.

The aperture element 10 or 20 embodying the invention is able to prevent or reduce uncontrolled scatter of electrons which might otherwise produce charge locations upstream of the element. Consequently, drift of the beam position due to electron charging is eliminated or reduced.

## Claims

1. An electron beam aperture element comprising a beam travel control member provided with a passage opening for travel therethrough of at least part of an electron beam and with a blocking surface for blocking travel of part or all of the beam through the passage opening, **characterised in that** the aperture element further comprises a trap chamber which serves to trap scattered electrons resulting from blocking or partial blocking of the beam and which has an entrance for the beam at such a spacing from the passage opening that the majority of scattered electrons within the chamber is dispersed therein before reaching the entrance, and a shielding member which is disposed in the chamber to extend between the chamber entrance and the passage opening over at least the major part of said spacing and which has a smaller surface area than the wall of the chamber so as to be liable to be charged by the electrons to a lower potential than the wall thereby to electrically shield the beam relative to the wall.

2. An aperture element according to claim 1, **characterised in that** the shielding member comprises an apertured wall member bounding a through passage.

3. An aperture element according to claim 2, **characterised in that** the apertured wall member is formed by a grid or grill.

4. An aperture element according to claim 2 or claim 3, **characterised in that** the apertured wall member is substantially cylindrical.

5. An aperture element according to any one of the preceding claims, **characterised in that** the shielding member extends over substantially all of said spacing.

6. An aperture element according to any one of the preceding claims, **characterised in that** the trap chamber is bounded by a substantially cylindrical inner wall surface of a hollow body and by an inwardly directed face of a closure plate closing the cavity of the body at one end thereof, the closure plate having a central passage opening providing the chamber entrance.

7. An aperture element according to claim 6, **characterised in that** the closure plate is provided with at least one further passage opening disposed outwardly of the central passage opening and serving for vacuum equalisation between the interior and the exterior of the aperture element when installed in an electron beam column.

8. An aperture element according to claim 7, **characterised in that** the inner wail surface of the hollow body has an outwardly directed step adjacent to the closure plate and the or each further passage opening in the plate is aligned with a radial face of the step.

9. An aperture element according to any one of claims 6 to 8, **characterised in that** the control member is mounted in the body in the region of an opposite end of the body cavity.

10. An aperture element according to claim 9, **characterised in that** the blocking surface is substantially planar.

11. An aperture element according to claim 10, **characterised in that** the control member comprises a plate.

12. An aperture element according to claim 9, **characterised in that** the blocking surface is substantially frusto-conical.

13. An electron beam column comprising a casing, beam generating means arranged in the casing and operable to generate an electron beam, and at least one aperture element according to any one of the preceding claims arranged in the casing to be in the path of the beam.

14. A column according to claim 13, **characterised in that** the at least one aperture element is arranged in the column to function as a spray aperture.

15. A column according to claim 13, **characterised in that** the at least one aperture element is arranged in the column to function as a blanking aperture.

## Patentansprüche

1. Elektronenstrahlblendenelement, umfassend ein Strahlausbreitungssteuerglied, versehen mit einer Durchlaßöffnung für die Ausbreitung mindestens eines Teils eines Elektronenstrahls dort hindurch, und mit einer Blockieroberfläche zum Blockieren der Ausbreitung eines Teils des oder des ganzen Strahls durch die Durchgangsöffnung, **dadurch gekennzeichnet, daß** das Blendenelement weiterhin eine Einfangkammer umfaßt, die dazu dient, sich aus dem Blockieren oder teilweisen Blockieren des Strahls resultierende gestreute Elektronen einzufangen, und die einen Eingang für den Strahl in einem derartigen Abstand von der Durchgangsöffnung aufweist, daß der größte Teil gestreuter Elektronen innerhalb der Kammer darin zerstreut wird, bevor er den Eingang erreicht, und ein abschirmendes Glied, das in der Kammer angeordnet ist und sich zwischen dem Kammereingang und der Durchgangsöffnung über mindestens den größeren Teil des Abstands erstreckt und das einen kleineren Flächeninhalt als die Wand der Kammer aufweist, um von den Elektronen auf ein niedrigeres Potential als die Wand aufgeladen werden zu können, um **dadurch** den Strahl relativ zur Wand elektrisch abzuschirmen.

2. Blendenelement nach Anspruch 1, **dadurch gekennzeichnet, daß** das abschirmende Glied ein mit einer Blende versehenes Wandglied umfaßt, das einen Durchgang begrenzt.

3. Blendenelement nach Anspruch 2, **dadurch gekennzeichnet, daß** das mit einer Blende versehene Wandglied von einem Gitter oder Grill ausgebildet wird.

4. Blendenelement nach Anspruch 2 oder 3, **dadurch gekennzeichnet, daß** das mit einer Blende versehene Wandglied im wesentlichen zylindrisch ist.

5. Blendenelement nach einem der vorhergehenden Ansprüche, **dadurch gekennzeichnet, daß** sich das abschirmende Glied im wesentlichen über den gesamten Abstand erstreckt.

6. Blendenelement nach einem der vorhergehenden Ansprüche, **dadurch gekennzeichnet, daß** die Einfangkammer von einer im wesentlichen zylindrischen Innenwandoberfläche eines Hohlkörpers und von einer nach innen gerichteten Fläche einer Verschlußplatte begrenzt wird, die den Hohlraum des Körpers an einem Ende davon abschließt, wobei die Verschlußplatte eine zentrale Durchgangsöffnung aufweist, die den Kammereintritt bereitstellt.

7. Blendenelement nach Anspruch 6, **dadurch gekennzeichnet, daß** die Verschlußplatte mit mindestens einer weiteren außerhalb der zentralen Durchgangsöffnung angeordneten Durchgangsöffnung versehen ist, die zum Vakuumausgleich zwischen dem Inneren und dem Äußeren des Blendenelements dient, wenn in einer Elektronenstrahlsäule installiert.

8. Blendenelement nach Anspruch 7, **dadurch gekennzeichnet, daß** die Innenwandoberfläche des Hohlkörpers eine nach außen gerichtete Stufe neben der Verschlußplatte aufweist und die oder jede weitere Durchgangsöffnung in der Platte auf eine radiale Fläche der Stufe ausgerichtet ist.

9. Blendenelement nach einem der Ansprüche 6 bis 8, **dadurch gekennzeichnet, daß** das Steuerglied im Körper im Gebiet eines gegenüberliegenden Endes des Körperhohlraums montiert ist.

10. Blendenelement nach Anspruch 9, **dadurch gekennzeichnet, daß** die blockierende Oberfläche im wesentlichen planar ist.

11. Blendenelement nach Anspruch 10, **dadurch gekennzeichnet, daß** das Steuerglied eine Platte umfaßt.

12. Blendenelement nach Anspruch 9, **dadurch gekennzeichnet, daß** die blockierende Oberfläche im wesentlichen kegelstumpfförmig ist.

13. Elektronenstrahlsäule, umfassend ein Gehäuse, Strahlerzeugungsmittel, in dem Gehäuse angeordnet und dahingehend betätigbar, daß sie einen Elektronenstrahl erzeugen, und mindestens ein Blendenelement nach einem der vorhergehenden Ansprüche, so in dem Gehäuse angeordnet, daß es sich im Weg des Strahls befindet.

14. Säule nach Anspruch 13, **dadurch gekennzeichnet, daß** das mindestens eine Blendenelement in der Säule angeordnet ist, um als eine Sprühblende zu dienen.

15. Säule nach Anspruch 13, **dadurch gekennzeichnet, daß** das mindestens eine Blendenelement in der Säule angeordnet ist, um als eine Austastblende zu dienen.

## Revendications

1. Elément à ouverture pour faisceau d'électrons, comprenant une pièce de commande de propagation de faisceau dotée d'un trou de passage à travers lequel une partie au moins d'un faisceau d'électrons est destinée à se propager et dotée d'une surface de blocage pour bloquer la propagation d'une partie ou de la totalité du faisceau à travers le trou de passage, **caractérisé en ce qu'**il comprend en outre une chambre de piégeage servant à piéger des électrons diffusés issus du blocage total ou du blocage partiel du faisceau et comportant une entrée pour le faisceau dont l'espacement par rapport au trou de passage est tel que la majorité des électrons diffusés au sein de la chambre y sont dispersés avant d'atteindre l'entrée, et une pièce de blindage disposée dans la chambre de façon à se prolonger entre l'entrée de la chambre et le trou de passage sur la majeure partie au moins dudit espacement et dont la superficie est inférieure à celle de la paroi de la chambre, de façon à ce qu'elle soit susceptible d'être chargée par les électrons à un potentiel inférieur à celui de la paroi pour assurer ainsi le blindage électrique du faisceau vis-à-vis de la paroi.

2. Elément à ouverture selon la revendication 1, **caractérisé en ce que** la pièce de blindage comprend une pièce de paroi dotée d'une ouverture délimitant un passage traversant.

3. Elément à ouverture selon la revendication 2, **caractérisé en ce que** la pièce de paroi dotée d'une ouverture est formée d'une grille.

4. Elément à ouverture selon la revendication 2 ou la revendication 3, **caractérisé en ce que** la pièce de paroi dotée d'une ouverture est sensiblement cylindrique.

5. Elément à ouverture selon l'une quelconque des revendications précédentes, **caractérisé en ce que** la pièce de blindage se prolonge sensiblement sur la totalité dudit espacement.

6. Elément à ouverture selon l'une quelconque des revendications précédentes, **caractérisé en ce que** la chambre de piégeage est délimitée par une surface de paroi intérieure sensiblement cylindrique d'un corps creux et par une face dirigée vers l'intérieur d'une plaque d'obturation qui obture la cavité du corps au niveau d'une de ses extrémités, la plaque d'obturation comportant un trou de passage central formant l'entrée de la chambre.

7. Elément à ouverture selon la revendication 6, **caractérisé en ce que** la plaque d'obturation est pourvue d'au moins un trou de passage supplémentaire disposé vers l'extérieur du trou de passage central et servant à égaliser le vide entre l'intérieur et l'extérieur de l'élément à ouverture lorsqu'il est installé dans une colonne à faisceau d'électrons.

8. Elément à ouverture selon la revendication 7, **caractérisé en ce que** la surface de paroi intérieure du corps creux comporte un gradin dirigé vers l'extérieur, adjacent à la plaque d'obturation, et le ou chaque trou de passage supplémentaire dans la plaque est aligné sur une face radiale du gradin.

9. Elément à ouverture selon l'une quelconque des revendications 6 à 8, **caractérisé en ce que** l'élément de commande est monté dans le corps dans la région d'une extrémité opposée de la cavité du corps.

10. Elément à ouverture selon la revendication 9, **caractérisé en ce que** la surface de blocage est sensiblement plane.

11. Elément à ouverture selon la revendication 10, **caractérisé en ce que** l'élément de commande comprend une plaque.

12. Elément à ouverture selon la revendication 9, **caractérisé en ce que** la surface de blocage est sensiblement tronconique.

13. Colonne à faisceau d'électrons comprenant un boîtier, un moyen de génération de faisceau d'électrons agencé dans le boîtier et capable de fonctionner pour générer un faisceau d'électrons, et au moins un élément à ouverture selon l'une quelconque des revendications précédentes agencé dans le boîtier de façon à se trouver dans la trajectoire du faisceau.

14. Colonne selon la revendication 13, **caractérisée en ce que** ledit au moins un élément à ouverture est agencé dans la colonne pour jouer le rôle d'ouverture de pulvérisation.

15. Colonne selon la revendication 13, **caractérisée en ce que** ledit au moins un élément à ouverture est agencé dans la colonne pour jouer le rôle d'ouverture de suppression de faisceau.
